# EUROPEAN PATENT APPLICATION

(11) **EP 0 643 443 A1**
(43) Date of publication of application: **15.03.1995**
(21) Application number: 94203023.0
(22) Date of filing: 17.04.1989
(51) Int. Cl.: H01R 9/09, H01R 23/70

(54) **Power connector for connection to a printed circuit board**

(62) Divisional of application: 89200986.1
(71) Applicant: CONNECTOR SYSTEMS TECHNOLOGY N.V., Willemstad Curaçao (AN)
(72) Inventor: Verhoeven, Laurentius Maria, NL-5465 RV Veghel (NL)
(74) Representative: de Bruijn, Leendert C.

(57) **Abstract**

A power connector comprising at least one contact member provided with a contact end, surrounded by a housing, and with an elongated connection portion (43) of electrically conducting material for connecting the power connector to a printed circuit board (2), the connecting portion (43) being provided with a slot-shaped opening (45) in which the printed circuit board can be received for connecting the power connector to one or both flat sides of said board by a surface mounting technique, said connecting portion (43) being integrally made with said contact socket (42) or said contact pin (52).

## Description

The present invention relates to a power connector comprising at least one contact member provided with a contact end, surrounded by a housing, and with an elongated connection portion of electrically conducting material for connecting the power connector to a printed circuit board.

Such a power connector is known from United States patent 4.702.707. The problem to be solved in that patent is to provide a power connecter having a removable mating component so that a damaged component can be easily replaced. To solve this problem a connector is provided with a base provided with a threaded bore opening out onto opposing surfaces and terminal pins for being soldered in holes in a printed circuit board for electrical engagement with power circuits thereon. By means of a screwdriver the mating component can be removed and replaced from the base.

United States patent 3.426.311 discloses a transition device for connecting a coaxial transmission line to a strip line. In order to provide a reasonable rigid and dimensionally accurate structure to obtain minimum electrical discontinuity, the disclosed transition device comprises means for clamping the outer conductor of the coaxial line in abutting relation with the ends of shield plates of a strip line. The coaxial line comprises an inner conductor provided with a slot for receiving the end of a center conductor of the strip line and, preferably, being soldered thereto.

A connector module generally comprises a housing of electrically insulative material which accommodates a plurality of contact elements or terminals arranged in rows and columns. The contact elements have a base section and a contact end and connecting end extending from opposite ends of the base section. The connecting ends project outside one side of the housing and are connected to a printed circuit board.

There have long been attempts to accommodate electronic circuits in as modular a design as possible on printed circuit boards of standard dimensions. The interconnections between the individual modules and components, such as recorders, playback devices, etc., are preferably made via electronic connectors. As a consequence of miniaturization and due to the high density of present day integrated circuits, a large number of electronic components can be mounted on a printed circuit board so that a large number of functions can be carried out by a module of this type. The number of terminals needed for connection to other modules has, likewise, increased.

As a result, there is a great need for connectors with a high contact element density, i.e., with a large number of electrical contacts or terminals per unit of volume. The need for connectors with high contact element density has become even greater as a result of the advent of surface mounting technology whereby electronic components are surface mounted to the printed circuit board. Surface mounted devices (SMD) are not mounted on a printed circuit board via the usual pinhole connection but are connected directly to the surface of the printed circuit itself. By surface mounting techniques, it is possible to mount electronic components readily on either surface of a board without interfering with connecting pins which project through the board. This results in a component density which is even higher than that achieved with conventional pinhole connections and a further increase in the number of terminals.

The object of the present invention is to provide a power connector of a type defined in the preamble of claim 1 which is able to directly contact a printed circuit board by surface mounting.

Therefore the power connector according to the invention is characterized in that the connecting portion is provided with a slot-shaped opening in which the printed circuit board can be received for connecting the power connector to one or both flat sides of said board by a surface mounting technique, said connecting portion being integrally made with said contact socket or said contact pin.

Connectors designed in this manner possess sufficient mechanical stability and a sufficiently large contact surface so that reliable and mechanically stable connections with a printed circuit board can be made by surface mounting technique.

The contact end may be spring-loaded for receiving a contact pin or may be pin-shaped.

Several power connectors according to the invention may be accommodated in a common connector module housing.

In this application, the term "printed circuit board", which is also commonly referred to as "printing wiring board", is understood as meaning, in general, substrates with conducting tracks and thus, for example, also substrates of liquid crystal displays.

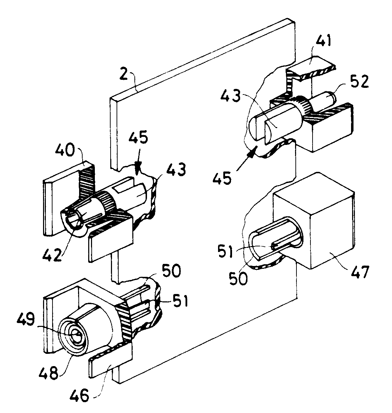

In the text which follows, the invention will be illustrated in detail by reference to a single figure of a preferred embodiment of a power connector for surface mounting technique.

The single figure shows diagrammatically in perspective power and coaxial connectors connected surface mounted to a printed wiring board.

The figure shows diagrammatically in perspective and in partially cut-away view, power connectors 40, 41 and coaxial connectors 46, 47 for connecting by surface mounting feed cables and coaxial cables to a printed circuit board. Connectors described in the parent European patent application 0,393,251 are less suitable for connecting feed cables carrying a relatively large current.

The unipolar power connector 40 is essentially constructed from a contact socket 42 of electrically conducting material having a spring-loaded contact end for receiving a contact pin and an elongated socket-shaped connecting end 43 for connection to a printed wiring board. The power connector 41 has a pin-shaped contact end 52 and a similar socket-shaped connecting end 43. In order to make it possible to connect the connecting end to a printed circuit board by surface mounting, the elongate connecting end 43 is provided, according to the invention, with a slot-shaped recess 45 in which the printed circuit board 2 may be received so that the connecting end 43 can be connected to the printed circuit board 2 at the two opposite flat sides thereof.

For connecting coaxial plugs, coaxial connectors 46, 47 are used in practice. These connectors have an elongated outermost contact socket 48 and innermost contact socket 49 which are electrically insulated from each other and respectively an outermost contact socket and an innermost contact pin (not shown) of electrically conducting material.

To permit surface mounting of the coaxial connectors to a printed circuit board, a part of the connecting end of the outermost contact socket 48 is removed from the circumference so that the remaining, virtually semicylindrical connecting end 50 can be connected to one side of the printed circuit board 2. Part of the jacket of the innermost contact socket 49, or the innermost contact pin, is removed so that the remaining connecting tongue 51 can be connected to the other side of the printed circuit board 2.

The connectors designed in this manner possess sufficient mechanical stability and a sufficiently large contact surface so that reliable and mechanically stable connections with a printed circuit board can be made by surface mounting technique. In practice, of course, it is possible, as a departure from the embodiments shown in the figure, for several coaxial connectors and/or several power connectors to be accommodated in a single module housing.

It will be clear that the invention is not limited to the preferred embodiment thereof described and shown in the drawing, but that other variations and modifications are possible. For example, the connector modules may include optoelectronic connectors connected to optical fiber cables, shielded connectors, to locking means or so called polarity indicators to prevent incorrect connection of the connector modules, etc., all without deviating from the scope of the invention which is defined by the claims.

## Claims

1. A power connector comprising at least one contact member provided with a contact end, surrounded by a housing, and with an elongated connection portion (43) of electrically conducting material for connecting the power connector to a printed circuit board (2) characterized in that the connecting portion (43) is provided with a slot-shaped opening (45) in which the printed circuit board can be received for connecting the power connector to one or both flat sides of said board by a surface mounting technique, said connecting portion (43) being integrally made with said contact socket (42) or said contact pin (52).

2. A power connector according to claim 1 characterized in that said contact end is spring-loaded for receiving a contact pin.

3. A power connector according to claim 1 characterized in that said contact end (52) is pin-shaped.

4. A connector module housing comprising several power connectors according to any of the preceding claims.
